**Europäisches Patentamt**

**European Patent Office**

**Office européen des brevets**

(19)

(11) Veröffentlichungsnummer : **0 383 776 B1**

(12) **EUROPÄISCHE PATENTSCHRIFT**

(45) Veröffentlichungstag der Patentschrift :
**21.06.95 Patentblatt 95/25**

(51) Int. Cl.$^6$ : **H01L 39/14, H01B 12/00**

(21) Anmeldenummer : **88907638.6**

(22) Anmeldetag : **02.09.88**

(86) Internationale Anmeldenummer :
**PCT/DE88/00544**

(87) Internationale Veröffentlichungsnummer :
**WO 89/02656 23.03.89 Gazette 89/07**

(54) **UMHÜLLUNG VON SUPRALEITENDEN DRÄHTEN.**

(30) Priorität : **17.09.87 DE 3731266**

(43) Veröffentlichungstag der Anmeldung :
**29.08.90 Patentblatt 90/35**

(45) Bekanntmachung des Hinweises auf die
Patenterteilung :
**21.06.95 Patentblatt 95/25**

(84) Benannte Vertragsstaaten :
**CH FR GB IT LI**

(56) Entgegenhaltungen :
**EP-A- 0 297 707**
**EP-A- 0 305 820**
**APPLIED PHYSICS LETTERS, Band 51, Nr. 3,
20. Juli 1987, American Institute of Physics, S.
JIN et al. : "High Tc superconductors-composite wire fabrication", Seiten 203-204**

(56) Entgegenhaltungen :
**Commission of European Community, European Workshop on High Tc Superconductors
and Potential Application, Proceedings, 1-3
July 1987, (IT), P. DUBOTS et al. : "First characterizations of high Tc superconducting
oxide based multifilamentary wires", Seiten
133-135**

(73) Patentinhaber : **Forschungszentrum Karlsruhe
GmbH
Weberstrasse 5
D-76133 Karlsruhe (DE)**

(72) Erfinder : **FLÜKIGER, René
Schneidemühlerstr. 6 e
D-7500 Karlsruhe (DE)**

(74) Vertreter : **Gottlob, Peter
Forschungszentrum Karlsruhe GmbH
Stabsabteilung
Patente und Lizenzen
Weberstrasse 5
D-76133 Karlsruhe (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 383 776 B1

## Beschreibung

Die Erfindung betrifft eine Umhüllung von supraleitenden Drähten,
- deren supraleitendes Material aus einem Oxid besteht, dessen supraleitende Eigenschaften sich während der Herstellung der Drähte und der Umhüllung durch Ziehen oder ähnliche Verformungsprozesse verschlechtern und
- die in umhülltem Zustand zur Wiederherstellung der ursprünglichen supraleitenden Eigenschaften oder zu deren weiterer Verbesserung einer Erholungsglühung und einer anschließenden Aufoxidierungsglühung unterzogen werden müssen.

Eine derartige Umhüllung ist beispielsweise aus Applied Physics Letters, Bd.51, Nr.3, 20.Juli 1987, S.203-204 bekannt.

In technisch nutzbaren supraleitenden Drähten muß das supraleitende Oxid von einer Hülle aus Metall umgeben sein. Dieses metallische Hüllmaterial erfüllt mehrere wichtige Aufgaben:

Es minimiert die Aufheizung bei lokalen Verlusten der supraleitenden Eigenschaft des Oxids und trägt damit dazu bei, daß nicht die supraleitende Eigenschaft der gesamten Einheit durch Überschreiten der Sprungtemperatur verloren geht und es stützt das spröde supraleitende Oxid gegen die meist nicht vermeidbare mechanische Beanspruchung ab, die während der Herstellung, aber auch durch die Lorentz-Kraft beim Betrieb eines Supraleiters auftritt.

Weiterhin muß das Hüllmaterial den supraleitenden Kern bei Temperaturen unterhalb 300 K gegenüber der Atmosphäre luftdicht verschließen, damit der Sauerstoffgehalt sowohl bei der Lagerung als auch beim Betrieb erhalten bleibt.

Alle bekannten Hochfeldsupraleiter mit $B_{C2}$ > 15 Tesla zeichnen sich durch eine außerordentliche Brüchigkeit aus. Diese Eigenschaft beeinflußt ganz wesentlich das Herstellungsverfahren von Drähten. Drähte mit Hochfeldsupraleitern wie $YBa_2Cu_3O_7$ oder davon abgeleiteten Oxiden (Substitution von Y durch Seitene Erden) können gegenwärtig nur durch pulvertechnologische Methoden hergestellt werden.

Hierbei wird die bereits gebildete (vorreagierte) supraleitende Phase in ein Metallrohr gefüllt, komprimiert und durch Verformungsprozesse wie Hämmern, Walzen oder Ziehen zu einem dünnen Draht mit einem Durchmesser von etwa 1 mm verformt.

In welcher Weise der Verformungsprozeß in der supraleitenden Phase im einzelnen abläuft, ist noch unbekannt, jedoch können die Folgen der Verformung durch Messung der Sprungtemperatur $T_c$ und der kritischen Stromdichte $J_c$ nachgewiesen werden.

Bei $YBa_2Cu_3O_7$ und davon abgeleiteten Oxiden bleibt $T_c$ zwar konstant, jedoch nimmt der Anteil an supraleitender Phase und die kritische Stromdichte $J_c$ mit wachsendem Verformungsgrad ab. Die supraleitenden Eigenschaften verschwinden bei starker Verformung vollständig. Um später die ursprünglichen supraleitenden Eigenschaften wieder zu erhalten, sind Erholungsglühungen notwendig, die üblicherweise bei Temperaturen oberhalb 800° C, häufig bei etwa 900° C bis maximal 940° C durchgeführt werden, an die sich eine Aufoxidierungsglühung anschließt.

Als Hüllmaterial wird zur Herstellung von Hochfeldsupraleiterdrähten bisher nahezu ausschließlich reines Silber verwendet (Proc. 1. European Workshop on High $T_c$ Superconductors and Potential Applications, P. Dubots et al, p. 133, G. Barani et al, p. 137, R. Flükiger et al, p. 131 sowie S. Jin et al, Appl. Phys. Lett. 51 (1987) 203).

Reines Silber ist für diesen Zweck aus mehreren Gründen gut geeignet. Es ist duktil, sein Schmelzpunkt liegt in Luft bei 960,8° C und in reiner Sauerstoffatmosphäre bei 939° C, es geht bei einer Glühung keine Reaktion mit dem oxidischen Supraleiter ein und schließlich ist es für Sauerstoff bei Temperaturen oberhalb von 400° C durchlässig. Unter wirtschaftlichen Gesichtspunkten wird der Preis von Silber für den vorgesehenen Verwendungszweck noch als akzeptabel angesehen.

Jin et al schlagen zwar als Hüllmaterial Kupfer mit einer Diffusionsbarriere aus Nickel/Gold vor; Kupfer ist jedoch wegen der irreversiblen Bildung von Kupferoxid weniger geeignet.

Die oben erwähnte Erholungsglühung wird bei dem Supraleiter vom Typ $YBa_2Cu_3O_7$ meist bei Temperaturen knapp unterhalb des Schmelzpunktes von Silber in Sauerstoffatmosphäre durchgeführt. An diese Erholungsglühung schließt sich dann eine Aufoxidierungsglühung bei etwa 400° C - 700° C an, bei der der Sauerstoffverlust im oxidischen Supraleitungsmaterial $YB_2Cu_3O_7$, der bei 900° C etwa 2 % beträgt, wieder ersetzt wird.

Unsere Untersuchungen haben ergeben, daß die kritische Stromdichte von supraleitenden $YBa_2Cu_3O_7$-Drähten wesentlich erhöht werden kann, wenn die Erholungsglühung nicht bei 900° C, maximal 939° C, sondern bei Temperaturen im Bereich zwischen 940° und 1030° C durchgeführt wird, somit in einem Temperaturbereich, in dem Silber in Sauerstoffatmosphäre bereits schmilzt.

Der Erfindung liegt somit die Aufgabe zugrunde, ein Hüllmaterial für supraleitende Drähte zu finden, das

2

zumindest die selben, oben erwähnten günstigen Eigenschaften aufweist wie Silber, das jedoch bei höherer Temperatur schmilzt, so daß mit diesem Hüllmaterial die Erholungsglühung im optimalen Temperaturbereich bei Temperaturen über 940° C bis zu 1030° C durchgeführt werden kann.

Die Kosten für dieses Hüllmaterial sollen den Preis von Silber nicht erheblich überschreiten.

Die Aufgabe wird für den Vertragsstaat IT erfindungsgemäß dadurch gelöst, daß die Umhüllung aus einer Silberlegierung besteht, deren Schmelzpunkt über dem Schmelzpunkt von reinem Silber liegt.

Eine Umhüllung des eingangs genannten Art, die aus Silber/Palladium-Legierungen mit einem Palladiumanteil von 5 bis 20 Gew.-% besteht, ist aus der älteren, unter Artikel 54(3) und 54(4) EPÜ fallenden europäischen Patentanmeldung EP-A-0 297 707 für die Vertragsstaaten CH, FR, GB und LI bekannt. Diese Legierungen werden für die genannten Vertragsstaaten in der vorliegenden Anmeldung nicht beansprucht.

Eine solche Silberlegierung kann dadurch hergestellt werden, daß dem Silber mindestens eines der Elemente der Gruppe Gold, Palladium, Platin, Mangan und Titan zulegiert wird.

In der folgenden Tabelle sind beispielhaft solche Silberlegierungen aufgeführt, die einen Schmelzpunkt von mindestens 1000° C aufweisen.

```
Tabelle
```

| Legierung | Zusammensetzung *) | Schmelzpunkt |
|---|---|---|
| Ag-Au | 35 Gew-% Au | 1000° C |
| Ag-Mn | 23 Gew-% Mn | 1000° C |
|  | 31 Gew-% Mn | 1071° C |
| Ag-Pd | 10 Gew-% Pd | 1000° C |
|  | 20 Gew-% Pd | 1070° C |
| Ag-Pt | 20 Gew-% Pt | 1000° C |
|  | 35 Gew-% Pt | 1050° C |
| Ag-Ti | 3 Gew.% Ti | 1017° C |

```
*) Differenz zu 100 Gew-%: Ag
```

Die oben angeführten günstigen Eigenschaften des reinen Silbers werden durch die Zumischung eines Legierungsbestandteils aus der o. g. Gruppe nicht negativ beeinflußt.

Wie die nachfolgenden Beispiele zeigen, wird durch eine höhere Erholungsglühtemperatur der Wert der kritischen Stromdichte $J_c$ beträchtlich erhöht. Die Erholungsglühtemperatur kann jedoch nur dann auf Werte oberhalb der bisher angewandten Temperatur von ca. 900° C, max. 939° C angehoben werden, wenn ein Hüllmaterial mit den günstigen Eigenschaften von Silber verwendet wird, dessen Schmelzpunkt jedoch höher ist als die Temperatur, bei der die Erholungsglühung zur Erzielung eines optimalen Ergebnisses durchgeführt werden muß.

Die Erfindung wird für den Vertragsstaat IT im folgenden anhand von Durchführungsbeispielen näher erläutert.

Beispiel 1

Ein supraleitender Draht wurde durch Ziehen eines mit $YBa_2Cu_3O_7$-Pulver gefüllten Rohrs (12 x 1,5 mm) aus einer Silber-Palladium-Legierung mit 8 Gew.-% Pd hergestellt. Das Hüllmaterial wies nach dem Ziehen einen äußeren Durchmesser von 1,15 mm und einen inneren Durchmesser von 0,85 mm auf.

Die Erholungsglühung wurde bei einer Temperatur von 970° C und einer Glühdauer von 80 min. vorgenommen. Danach wurde eine Aufoxidierungsglühung durchgeführt, wobei 6 Stunden lang eine Temperatur von 680° C und 48 Stunden lang eine Temperatur von 550° C aufrechterhalten wurde. Beide Glühungen wurden unter Sauerstoffatmosphäre durchgeführt. Der auf diese Weise hergestellte supraleitende Draht erreichte (auf den Querschnitt bezogen) eine kritische Stromdichte von 450 A/cm². Dieser Wert ist deutlich höher als der von Jin et al publizierte Wert von $J_c$ = 175 A/cm², der mit einem Hüllmaterial aus Silber und einer Erholungs- bzw. Aufoxidierungsglühtemperatur von 900° C bzw. 600° C erreicht wurde.

3

Beispiel 2

Ein supraleitender Draht wurde durch Ziehen eines mit YBa$_2$Cu$_3$O$_7$-Pulver gefüllten Rohrs (12 x 1 mm) aus einer Silber-Palladium-Legierung mit 20 Gew.-% Pd hergestellt. Das Hüllmaterial wies nach dem Ziehen einen äußeren Durchmesser von 0,4 mm und eine Wandstärke von 0,03 mm auf.

Die Erholungsglühung wurde bei einer Temperatur von 990° C mit einer Glühdauer von 75 min. vorgenommen. Danach wurde eine Aufoxidierungsglühung bei drei verschiedenen Temperaturstufen vorgenommen:
1) 6 Std./680° C
2) 24 Std./550° C
3) 48 Std./450° C.
Beide Glühungen wurden unter Sauerstoffatmosphäre durchgeführt.

Der auf diese Weise hergestellte supraleitende Draht erreichte (auf den Querschnitt bezogen) eine kritische Stromdichte von 680 A/cm².

**Patentansprüche**

**Patentansprüche für folgenden Vertragsstaat : IT**

1.  Umhüllung von supraleitenden Drähten,
    - deren supraleitendes Material aus einem Oxid besteht, dessen supraleitende Eigenschaften sich während der Herstellung der Drähte und der Umhüllung durch Ziehen oder ähnliche Verformungsprozesse verschlechtern und
    - die in umhülltem Zustand zur Wiederherstellung der ursprünglichen supraleitenden Eigenschaften oder zu deren weiterer Verbesserung einer Erholungsglühung und einer anschließenden Aufoxidierungsglühung unterzogen werden müssen,
    dadurch gekennzeichnet, daß
    die Umhüllung aus einer Silberlegierung besteht, deren Schmelzpunkt über dem Schmelzpunkt von reinem Silber liegt.

2.  Umhüllung nach Anspruch 1, dadurch gekennzeichnet, daß dem Silber mindestens eines der Elemente aus der Gruppe Gold, Palladium, Platin, Mangan und Titan zulegiert ist.

3.  Umhüllung nach Anspruch 2, dadurch gekennzeichnet, daß die Konzentration der zulegierten Elemente so gewählt ist, daß der Schmelzpunkt des Hüllmaterials über der optimalen Temperatur für die Erholungsglühung liegt.

**Patentansprüche für folgende Vertragsstaaten : CH, FR, GB, LI**

1.  Umhüllung von supraleitenden Drähten,
    - deren supraleitendes Material aus einem Oxid besteht, dessen supraleitende Eigenschaften sich während der Herstellung der Drähte und der Umhüllung durch Ziehen oder ähnliche Verformungsprozesse verschlechtern und
    - die in umhülltem Zustand zur Wiederherstellung der ursprünglichen supraleitenden Eigenschaften oder zu deren weiterer Verbesserung einer Erholungsglühung und einer anschließenden Aufoxidierungsglühung unterzogen werden müssen,
    wobei die Umhüllung aus einer Silberlegierung besteht, deren Schmelzpunkt über dem Schmelzpunkt von reinem Silber liegt, und Silber/Palladium-Legierungen mit einem Palladiumanteil von 5 bis 20 Gew.-% ausgenommen sind.

2.  Umhüllung nach Anspruch 1, dadurch gekennzeichnet, daß dem Silber mindestens eines der Elemente aus der Gruppe Gold, Palladium, Platin, Mangan und Titan zulegiert ist.

3.  Umhüllung nach Anspruch 2, dadurch gekennzeichnet, daß die Konzentration der zulegierten Elemente so gewählt ist, daß der Schmelzpunkt des Hüllmaterials über der optimalen Temperatur für die Erholungsglühung liegt.

4

## Claims

### Claims for the following Contracting State : IT

1. Covering for superconductive wires,
   - the superconductive material of which is formed from an oxide, the superconductive properties of which deteriorate during the production of the wires and the covering by drawing or similar deforming processes; and
   - which wires, when covered, must be subjected to a recovery annealing process and a subsequent oxidation annealing process to restore the original superconductive properties or to improve such further,
   wherein the covering is formed from a silver alloy, the melting point of which lies above the melting point of pure silver,

2. Covering according to claim 1, characterised in that at least one of the elements selected from the group including gold, palladium, platinum, manganese and titanium is alloyed with the silver.

3. Covering according to claim 2, characterised in that the concentration of the alloyed elements is so selected that the melting point of the covering material lies above the optimum temperature for the recovery annealing process.

### Claims for the following Contracting States : CH, FR, GB, LI

1. Covering for superconductive wires,
   - the superconductive material of which is formed from an oxide, the superconductive properties of which deteriorate during the production of the wires and the covering by drawing or similar deforming processes; and
   - which wires, when covered, must be subjected to a recovery annealing process and a subsequent oxidation annealing process to restore the original superconductive properties or to improve such further,
   wherein the covering is formed from a silver alloy, the melting point of which lies above the melting point of pure silver, and silver/palladium alloys having a palladium content of 5 to 20 % by wt. are excluded.

2. Covering according to claim 1, characterised in that at least one of the elements selected from the group including gold, palladium, platinum, manganese and titanium is alloyed with the silver.

3. Covering according to claim 2, characterised in that the concentration of the alloyed elements is so selected that the melting point of the covering material lies above the optimum temperature for the recovery annealing process.

## Revendications

### Revendications pour l'Etat contractant suivant : IT

1. Gaine de fils supraconducteur :
   - dont le matériau supraconducteur est composé d'un oxyde, dont les propriétés supraconductrices se détériorent pendant la fabrication des fils et de l'enveloppe par étirage ou processus semblables de formage et,
   - qui doivent être soumis à l'état gaine pour la reconstruction des propriétés supraconductrices d'origine ou pour leur amélioration ultérieure à un recuit de régénération et à un recuit d'oxydation successif,
   caractérisée en ce que la gaine est composée d'un alliage d'argent, dont le point de fusion se situe au-dessus du point de fusion de l'argent pur.

2. Gaine selon la revendication 1, caractérisée en ce qu'on ajoute par alliage à l'argent au moins un des éléments du groupe, or, palladium, platine, manganèse et titane.

3. Gaine selon la revendication 2, caractérisée en ce que la concentration des éléments alliés est choisie de façon, que le point de fusion du matériau de la gaine soit supérieur à la température optimale pour le recuit de régénération.

**Revendications pour les Etats contractants suivants : CH, FR, GB, LI**

1. Gaine de fils supraconducteur dont le matériau supraconducteur est composé d'un oxyde,
   - dont les propriétés supraconductrices se détériorent pendant la fabrication des fils et de l'enveloppe par étirage ou processus semblables de formage et,
   - qui doivent être soumis à l'état gainé pour la reconstruction des propriétés supraconductrices d'origine ou pour leur amélioration ultérieure à un recuit de régénération et à un recuit d'oxydation successif, fils dans lesquels la gaine est composée d'un alliage d'argent, dont le point de fusion se situe au-dessus du point de fusion de l'argent pur et des alliages d'argent/palladium avec une proportion de palladium de 5 à 20 % en poids sont exclus.

2. Gaine selon la revendication 1, caractérisée en ce qu'on ajoute par alliage à l'argent au moins un des éléments du groupe, or, palladium, platine, manganèse et titane.

3. Gaine selon la revendication 2, caractérisée en ce que la concentration des éléments alliés est choisie de façon, que le point de fusion du matériau de la gaine soit supérieur à la température optimale pour le recuit de régénération.